# EUROPÄISCHE PATENTSCHRIFT

(11) **EP 0 598 273 B1**
(45) Veröffentlichungstag und Bekanntmachung des Hinweises auf die Patenterteilung: **24.05.1995**
(21) Anmeldenummer: 93117698.6
(22) Anmeldetag: 02.11.1993
(51) Int. Cl.: H05K 3/00

(54) **Verfahren zum Behandeln von Leiterplatten bei Tauchvorgängen in chemischen Medien**
Method for treatment of circuit boards by dipping in chemical mediums
Procédé de traitement de circuits imprimés par trempage dans des milieux chimiques

(30) Priorität: 16.11.1992 DE 4238644
(43) Veröffentlichungstag der Anmeldung: 25.05.1994
(73) Patentinhaber: Siemens Nixdorf Informationssysteme Aktiengesellschaft, 33102 Paderborn (DE)
(72) Erfinder: Merkenschlager, Hans-Hermann, Dipl.-Ing., D-86179 Augsburg (DE)
(74) Vertreter: Fuchs, Franz-Josef, Dr.-Ing.

(56) Entgegenhaltungen:
- EP-A- 0 324 189
- DE-A- 4 033 199
- US-A- 4 854 040

## Beschreibung

Die Erfindung betrifft ein Verfahren zum Behandeln von Leiterplatten bei Tauchvorgängen in chemische Medien enthaltenden, in einem Behälter befindlichen Bädern.

Bei bisherigen Tauchvorgängen von Leiterplatten werden diese in einem Abstand von ca. 2 cm in Körbe geschichtet. Diese Körbe werden in das Behandlungsmedium vertikal eingetaucht. Die kompakte Anordnung der Leiterplatten reduziert zwar das Badvolumen und die Anlagenfläche, jedoch ist damit der Nachteil verbunden, daß der Produktionsfluß unterbrochen wird, z.B. daß die Leiterplatten von der horizontalen in die vertikale Richtung gebracht werden müssen, wenn sie in den Körben gesammelt werden, und daß das Beschicken und Entleeren der Körbe personellen Aufwand erfordert. Außerdem wird die Durchflutung kleiner Bohrungen behindert, sowie die Badverschleppung erhöht.

Es ist auch bekannt, Leiterplatten maschinell von der horizontalen in die senkrechte Lage umzuklappen und sie anschließend in das chemische Behandlungsmedium abzusenken. Dort werden sie in vertikaler Lage getaktet durch das Behandlungsmedium gefahren. Nach Abschluß der Behandlungszeit werden die Leiterplatten vertikal am anderen Ende des Behälters entnommen, in die Horizontale umgelegt und im Fertigungsprozeß horizontal weiterverarbeitet. Nachteilig ist hierbei der hohe maschinelle Aufwand sowie ebenfalls die mangelhafte Flutung kleiner Bohrungen, da das Eintauchen der Leiterplatte in das Behandlungsmedium in vertikaler Stellung erfolgt.

Aufgabe der vorliegenden Erfindung ist es, ein Verfahren zum Tauchen von Leiterplatten in ein chemisches Medium anzugeben, bei dem die Durchflutung der Bohrungen der Leiterplatten verbessert wird.

Zur Lösung dieser Aufgabe wird dabei so verfahren, daß in dem Behälter ein kreisförmiger, rundumlauender Fächerstapler eingesetzt ist, dessen Drehachse geringfügig über dem Badspiegel des chemischen Mediums liegt, und daß die Leiterplatten nacheinander horizontal in das jeweils nach einer Drehung über dem Badspiegel liegende Fach eingeschoben und während des Umlaufs festgehalten und nach dem Badumlauf auf der Gegenseite, wenn das Fach wieder horizontal über dem Badspiegel liegt, aus dem Bad geführt und in dieser Lage dem nächsten Prozeßschritt zugeleitet werden.

Der Vorteil dieser Lösung ist die Aufrechterhaltung des Fließprinzips, d.h. in der Richtung, in der die Platte ankommt, wird sie eingetaucht und auch wieder entnommen. Es ist keine manuelle Tätigkeit mehr erforderlich. Die Flutung kleiner Bohrungen ist durch das Eintauchen in horizontaler Stellung besser als beim Eintauchen in vertikaler Stellung, und die Anlage ist einfach und kostengünstig herzustellen. Die Badverschleppung ist bei dieser Anordnung geringer als bei einer üblichen Vertikaltauchanlage. Durch die Beibehaltung der kompakten Anordnung der Nutzen im Behandlungsmedium, wird die Länge der Fertigungsanlage gegenüber Fertigungsanlagen mit reinem Horizontaldurchlauf wesentlich verkürzt.

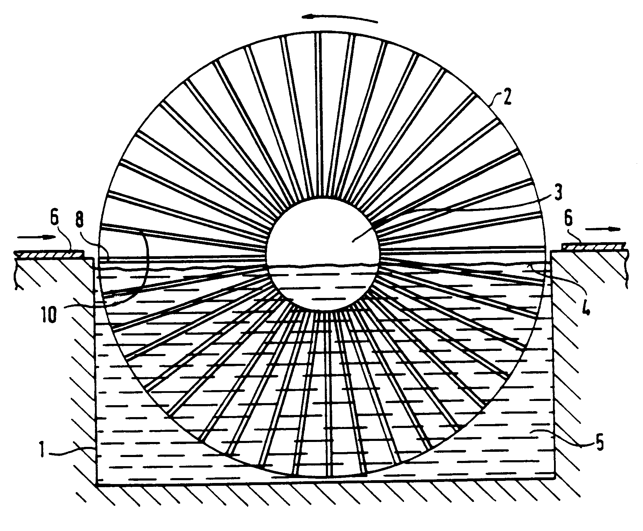

Anhand des Ausführungsbeispiels nach der Figur wird die Erfindung näher erläutert. In dem Behälter 1 mit dem chemischen Behandlungsmedium 5 wird der einem wasserradähnliche, kreisförmige Fächerstapler 2 eingesetzt. Die Drehachse 3 des Staplers liegt geringfügig über dem Badspiegel 4. Die Leiterplatte 6 bzw. ein aus mehreren Leiterplatten bestehender Nutzen werden horizontal in das jeweils über dem Bad befindliche Fach 8 eingeschoben und hier befestigt. Dann dreht sich der Stapler 2, dessen Fächer strahlenförmig von der Achse weg verlaufen, um eine Position weiter und senkt dabei die Leiterplatte 6 in das Bad. Nunmehr kann die nächste Leiterplatte in das darauffolgende Fach 10 eingeschoben werden usw. Nach Behandlungsabschluß wird die Leiterplatte 6 auf der Gegenseite horizontal aus dem Bad herausgeführt und in dieser Lage dem nächsten Prozeßschritt zugeleitet.

## Patentansprüche

1. Verfahren zum Behandeln von Leiterplatten bei Tauchvorgängen in chemische Medien enthaltenden, in einem Behälter befindlichen Bädern,
**dadurch gekennzeichnet**,
daß in dem Behälter (1) ein kreisförmiger, rundumlaufender Fächerstapler (2) eingesetzt ist, dessen Drehachse (3) geringfügig über dem Badspiegel (4) des chemischen Mediums (5) liegt, und daß die Leiterplatten (6) nacheinander horizontal in das jeweils nach einer Drehung unmittelbar über dem Badspiegel liegende Fach (8) eingeschoben und während des Umlaufs festgehalten und nach dem Badumlauf auf der Gegenseite, wenn das Fach (8) wieder horizontal über dem Badspiegel liegt, aus dem Bad geführt und in dieser Lage dem nächsten Prozeßschritt zugeleitet werden.

## Claims

1. Method for the treatment of printed circuit boards by dipping in baths containing chemical media and situated in a tank, characterized in that there is introduced into the tank (1) a circular compartment-type stacker (2) which rotates and the axis of rotation (3) of which lies slightly above the bath level (4) of the chemical medium (5), and in that the printed circuit boards (6) are successively pushed horizontally into the compartment (8) respectively lying directly above the bath level after one turn, are held fast during the rotation, are guided, after the rotation in the bath, out of the bath on the opposite side, when the compartment (8) again lies horizontally above the bath level, and are forwarded in this position to the next process step.

## Revendications

1. Procédé de traitement de plaques de circuit imprimé par des opérations d'immersion dans des bains se trouvant dans une cuve contenant des milieux chimiques,
caractérisé en ce qu'il consiste
à mettre dans la cuve (1) une roue à casiers (2), dont l'axe de rotation (3) se trouve légèrement au-dessus du niveau (4) du bain du milieu (5) chimique et à insérer les plaquettes de circuit imprimé (6) l'une après l'autre horizontalement dans le casier (8) se trouvant juste au-dessus du niveau du bain après une rotation et à les y maintenir pendant la rotation et, après qu'ils sont passés dans le bain, à les sortir du bain du côté opposé où le casier (8) se trouve à nouveau horizontalement au-dessus du niveau du bain et à les envoyer en cette position au stade opératoire suivant.
